# EUROPEAN PATENT SPECIFICATION

(11) **EP 1 529 854 B1**
(45) Date of publication and mention of the grant of the patent: **24.12.2008**
(21) Application number: 04256591.1
(22) Date of filing: 26.10.2004
(51) Int. Cl.: C23C 16/44, H01L 21/00

(54) **Cleaning gas mixture for an apparatus and cleaning method**
Reinigungs-Gaszusammensetzung zur Reinigung einer Vorrichtung und Reinigungsverfahren
Mélange gazeux pour nettoyage d'un appareillage et méthode de nettoyage

(30) Priority: 04.11.2003 JP 2003374160
(43) Date of publication of application: 11.05.2005
(73) Proprietor: Taiyo Nippon Sanso Corporation, Shinagawa-ku, Tokyo (JP)
(72) Inventor: Isaki, Ryuichiro, c/oTaiyo Nippon Sanso Corporation, Shinagawa-ku, Tokyo (JP); Shinriki, Manabu, c/oTaiyo Nippon Sanso Corporation, Shinagawa-ku, Tokyo (JP)
(74) Representative: Smyth, Gyles Darren

(56) References cited:
- EP-A- 0 464 696
- EP-A- 0 924 282
- EP-A- 1 318 542
- US-B1- 6 242 359
- OH C H ET AL: "Increase of cleaning rate and reduction in global warming effect during C4F8O/O2 remote plasma cleaning of silicon nitride by adding NO and N2O" THIN SOLID FILMS - PREPARATION AND CHARACTERIZATION, ELSEVIER SEQUOIA, NL, vol. 435, no. 1-2, 1 July 2003 (2003-07-01), pages 264-269, XP004431367 ISSN: 0040-6090

## Description

### BACKGROUND OF THE INVENTION

### Field of the Invention

The present invention relates to a cleaning gas and to a cleaning method. In particular, the present invention relates to a cleaning gas composition for dry cleaning to remove deposits such as silicon oxide films which has formed inside a semiconductor film forming device such as an apparatus for producing semiconductor devices, an offline surface modifying device, and a thin film forming apparatus, and relates to a cleaning method using the cleaning gas.

Priority is claimed on Japanese Patent Application No. 2003-374160, filed November 4, 2003, the content of which is incorporated herein by reference.

### Description of Related Art

A dry cleaning method may be used to remove (etch off) deposits by introducing a cleaning gas including fluorocarbon gases into a processing chamber and generating plasma in the processing chamber to remove deposits, for example, silicon oxide accumulated inside the chamber inside a semiconductor film forming device such as an apparatus for producing semiconductor devices, an offline surface modifying device, and a thin film forming apparatus. The cleaning gas used in these steps, may be fluorocarbon gas alone, but is usually fluorocarbon gas diluted with oxygen or rare gases 10 to 30 times (see for example Japanese Patent No. 2904723).

### SUMMARY OF THE INVENTION

Decreasing the quantity of fluorocarbon gases consumed, and decomposition and removal after use of fluorocarbon gases in processes are needed since many fluorocarbon gases have extremely high Global Warming Potential (GWP). Efficient ways of using fluorocarbon gases, which further decrease the quantity consumed, are needed which maintain process performance. On the other hand, it is known that the GWP of unsaturated fluorocarbon gas having double bond per molecule or a composition having an oxygen atom per molecule in a type of fluorocarbon gas becomes substantially less than that of saturated fluorocarbon gases since unsaturated fluorocarbon gases having at least one double bond per molecule or a composition having an oxygen per molecule are decomposed rapidly after release to the atmosphere.

These fluorocarbon gases which are short-lived in the atmosphere are represented by C₂F₄, C₃F₆, and C₃F₆O, and these gases are obtainable without new methods of synthesis of gases for the semiconductor processes and these have advantages in energy efficiency since these are raw materials for producing fluorocarbon type resins such as TEFLON (trademark), and are used in significantly large amounts in the chemical industry.

However, since these fluorocarbon gases which are short-lived in the atmosphere are easily polymerized, these gases cause a problem in that the etching rate generally decreases during cleaning of silicon oxide films, etc. Decreasing the etching rate causes problems in the removal times and in the removal efficiency of deposits inside the chamber in the cleaning process, and it is necessary to reduce the time so as to maintain the process efficiency.

Objects of the present invention are to provide a cleaning gas including fluorocarbon gas according to claim 1, which increases the speed of etching reactions and increases the cleaning efficiency, and a cleaning method using the cleaning gas, according to claim 2.

A cleaning gas of the present invention to achieve the object is a cleaning gas to remove deposits accumulated inside a semiconductor film forming device, and which includes a mixed gas containing a fluorocarbon gas, having at least one double bond per molecule, selected from the group comprising hexafluoropropene (C₃F₆), octafluorocyclopentene (C₅F₈) and hexafluorobutadiene (C₄F₆);
oxygen; and at least one selected from the group of nitrogen trifluoride, fluorine, nitrous oxide, nitrogen, and rare gases up to 10 % by volume based on the total gas volume.

A cleaning method of the present invention is a method to remove deposits accumulated inside a semiconductor film forming device, which includes a step of introducing the above mixed gas as a cleaning gas and a step of plasma excitation of the cleaning gas by exposure to high frequency electromagnetic radiation.

A cleaning mixture and method using a fluorocarbon and an oxygen-containing gas is known from US-B1-6242359.

By the present invention, removal of the deposits such as silicon oxide film accumulated inside a semiconductor film forming device at a high rate while suppressing the release of the global warming substances is possible.

The present invention increases the efficiency of use of the semiconductor film forming device since the present invention efficiently cleans off deposits such as silicon oxide accumulated inside the semiconductor film forming device such as an apparatus for producing semiconductor devices, an offline surface modifying device, and a thin film forming apparatus.

### BRIEF DESCRIPTION OF THE DRAWINGS

FIG. 1 is a graph showing the bond dissociation energy of each gas;
FIG. 2 is a graph showing the relationship between the concentration of nitrogen trifluoride and the etching rate in Comparative Example 1;
FIG 3 is a graph showing the relationship between the concentration of fluorocarbon gas and the etching rate in Comparative Example 2;
FIG. 4 is a graph showing the relationship between the addition amount of nitrogen trifluoride and the etching rate in Example 1;
FIG. 5 is a graph showing the relationship between the addition amount of nitrous oxide and the etching rate in Example 2;
FIG. 6 is a graph showing the relationship between the addition amount of nitrogen and argon, and the etching rate in Example 3;
FIG. 7 is a graph showing collectively the increasing ratio of etching rate when each of the additive gases is added in amounts of 10% by volume respectively; and
FIG. 8 is a graph showing the relationship between the addition amount of nitrogen and the etching rate in Example 6 (not being part of the invention).

### DETAILED DESCRIPTION OF THE INVENTION

A fluorocarbon gas used in the present invention is one selected from hexafluoropropene (C₃F₆), octafluorocyclopentene (C₅F₈), hexafluorobutadiene (C₄F₆), Among these compounds, hexafluoropropene which is a fluorocarbon gas having a double bond per molecule, is preferable.

Fluorocarbon gases having at least one double bond per molecule (unsaturated fluorocarbon gases) are considered to generally have a low etching rate; however, the etching rate can be increased by supplying radicals to the reaction environment which radicals react by addition reaction to the double bond per molecule. The double bond of the unsaturated fluorocarbon molecule has a high bond dissociation energy even though it has a low decomposition efficiency in plasma, and the chemical reactivity is high and reacts with various radicals at an extremely high rate. Applying these properties, the reaction environment which easily generates active species which contribute to the etching reaction can be obtained by adding gas having a reaction assist action to minimize the effect on the entire process. Furthermore, an effective plasma can be generated rapidly and the higher density active species can be produced by adding small quantities of gases of low breakdown voltage.

When these kinds of fluorocarbon gases are used as cleaning gases, mixed gases of these fluorocarbon gases and oxygen gas are added with small quantities of gases having an action to increase the cleaning rate (or the etching rate) (which is the reaction assist action). The mixing ratio of fluorocarbon gases and oxygen gas is optional and the mixing ratio can be set properly depending on the type of the fluorocarbon gas.

The addition gases having a reaction assist action indicates gases which easily generate radicals in plasma and gases having low breakdown voltage, and the gases which easily generate radicals in plasma indicate gases which easily generate F radicals, O radicals, and N radicals contributing to the etching reaction, specifically nitrogen trifluoride, fluorine, nitrous oxide, and the specific examples of the gases having low breakdown voltage are nitrogen and rare gasses (helium, neon, argon, krypton, xenon, and radon).

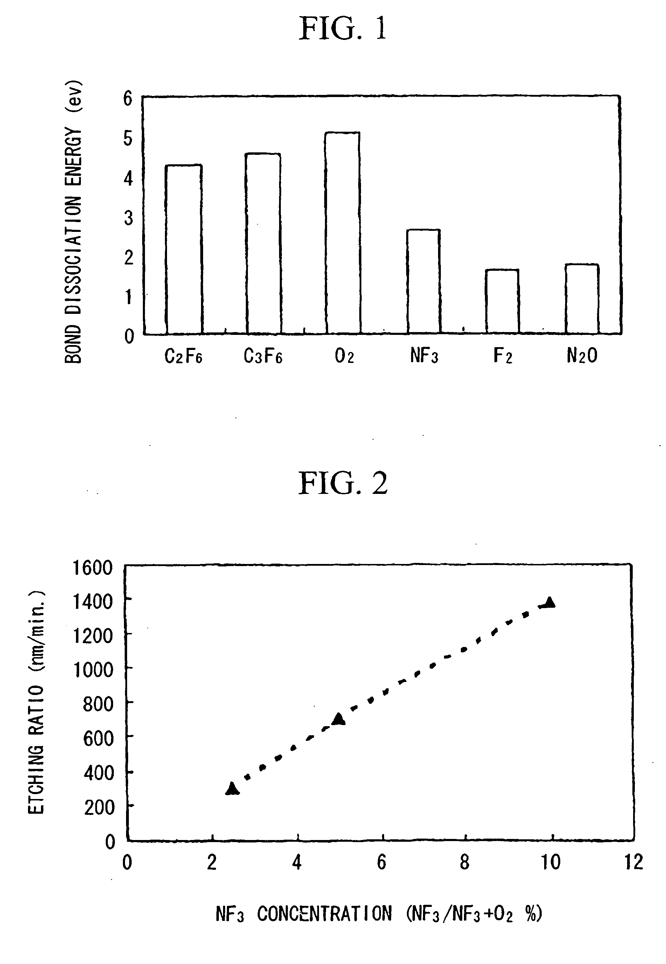

FIG. 1 is a graph showing the bond dissociation energy of hexafluoroethane and hexafluoropropene as a fluorocarbon gas, oxygen included in a cleaning gas, nitrogen trifluoride, fluorine, and nitrous oxide. The bond dissociation energy of nitrogen trifluoride, fluorine, and nitrous oxide which are higher dissociation gases in comparison to fluorocarbon gases and oxygen gas are substantially lower than those of the fluorocarbon gases, and radicals can be produced effectively. For example, by adding small quantities of the high dissociation gas such as nitrogen trifluoride to hexafluoropropene, F radicals generated from nitrogen trifluoride in plasma reacted by addition reaction to the double bond of hexafluoropropene, and CvFy radicals are easily generated. CvFy radicals are an essential active species to promote the etching reaction and the etching reaction considerably easier than that in the case without adding nitrogen trifluoride.

For example, when only hexafluoropropene is applied, two reactions which are the reaction generating radicals by the dissociation of the bonds of molecules and the reaction producing hexafluorocyclopropene by bond exchange reaction might compete and develop. The radical generation reaction can be said to be a generation reaction of precursors of F radicals which are the direct active species of etching of the silicone oxide film, and the radical generation reaction is a reaction which contributes to the etching reaction. Since the reaction producing hexafluorocyclopropene is a reaction which does not contribute to the etching reaction, the suppression of the reaction producing hexafluorocyclopropene is significantly important. By adding small quantities of nitrogen trifluoride, greater quantities of F radicals are supplied to the reaction environment, and instantly more quantities of C₃F₇ radicals which are the hexafluoropropene added by F radicals are generated, and then the effect that the generation reaction of hexafluorocyclopropene is substantively suppressed can be obtained.

In the case of the other fluorocarbon gases, adding small quantities of gases having the reaction assist action (which are the addition gases) is effective in lowering the spark-over voltage without significant change of the chemical composition of the entire reaction system, making the density of etching active species such as excited molecules or radicals higher and this might result in the progress of the etching reaction, that is the progress of the cleaning, easy. The addition amount of the addition gases having the reaction assist action is no more than 10% of the total gas amount when it is used as a cleaning gas. When a greater amount of addition gas was added to the cleaning gas, the chemical composition of the entire reaction system is changed significantly and this is not preferable.

The etching reaction progresses when nitrogen trifluoride or fluorine are used alone as a cleaning gas; however, the higher increasing effect of the etching reaction rate is obtained in the concentration range of the mixed gases of said fluorocarbon gases with small quantities of nitrogen trifluoride or fluorine in comparison to the etching performance with use of these gases alone.

The cleaning gas may be mixed by regulating the flow rate of each gas of addition gases, fluorocarbon gases, and oxygen gas by the mass flowmeter when the gas was introduced into the semiconductor equipment, and the cleaning gas which was mixed preliminarily and filled in the high-pressure gas bottle and so on may be used. The etching reaction progresses by the plasma excitation of the gas applying the high frequency electromagnetic radiation (e.g. 13.56 MHz) in the processing chamber in which the cleaning gas is introduced.

### Examples

The cleaning performance was evaluated by using various composition of gases. The cleaning performance was evaluated by measuring the etching rate of a silicon oxide film by using a parallel plate-type plasma device. The conditions of cleaning were:
thickness of silicon oxide film: 6000 Å (600 nm),
high frequency power: 700 W,
pressure in the chamber: 5.5 Torr (approximately 733 Pa),
substrate temperature: 400°C, and
total gas mass flow: 400 sccm.

### Comparative Example 1

A mixed gas of nitrogen trifluoride and oxygen was used as a cleaning gas. The relationship of the measurement results between the concentration of nitrogen trifluoride and the etching rate is shown in FIG. 2. As is clear from the figure, the etching rate of the silicon oxide film tends to increase linearly in proportion to the concentration of nitrogen trifluoride.

### Comparative Example 2

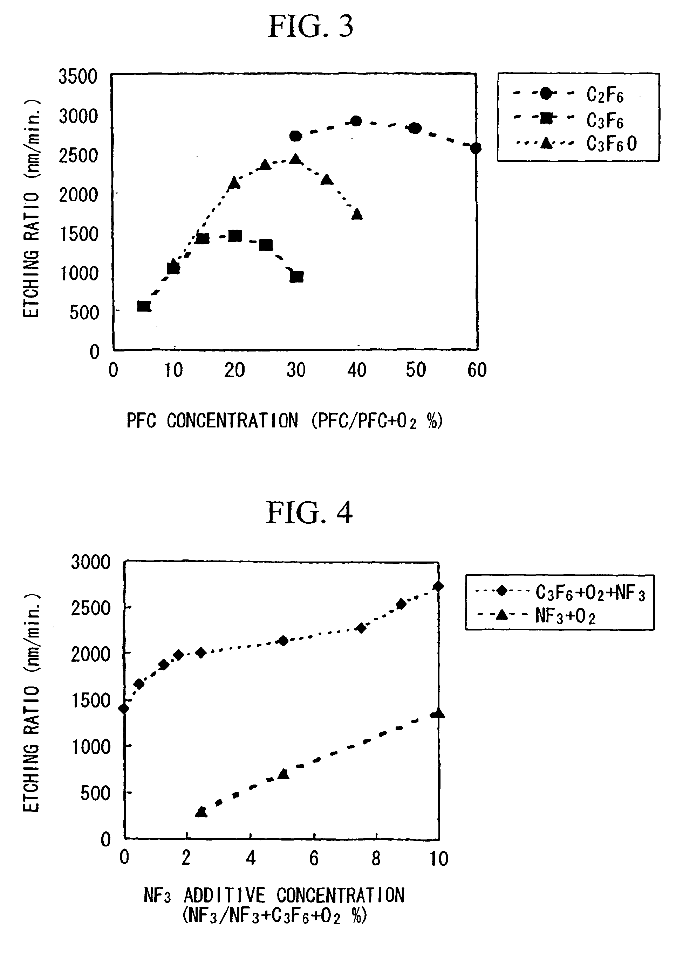

A mixed gas of each of hexafluoropropene, hexafluoroethane and hexafluoropropene oxide which are the fluorocarbon gases, and oxygen was used as a cleaning gas. The relationship of the measurement results between the concentration of each fluorocarbon gas and the etching rate is shown in FIG. 3.

From FIG. 3, the etching rate of the silicon oxide film tends to maximize in the concentration from 15% to 20% in the case of hexafluoropropene. The etching rate of the silicon oxide film in the case of hexafluoroethane is almost double that in the case of hexafluoropropene, and that in the case of hexafluoropropene oxide is almost 1.7 times faster than that in the case of hexafluoropropene. Comparing the hexafluoropropene and hexafluoroethane, the bond dissociation energies are almost the same and the number of F atoms per molecule is the same, and the difference of the etching rate may be said to be huge, and the difference of the etching rate occurs due to the difference of the reactive process in the plasma.

### Example 1

A mixed gas of hexafluoropropene and oxygen gas, to which is added nitrogen trifluoride, was used as a cleaning gas. The mixing ratio of hexafluoropropene and oxygen was based on 60 sccm: 340 sccm (the concentration of hexafluoropropene; 15%) and the amount of oxygen was reduced corresponding to the addition amount when nitrogen trifluoride was added. The relationship of the measurement results between the addition amount of nitrogen trifluoride and the etching rate is shown in FIG. 4.

From FIG. 4, the etching rate of the silicon oxide film tends to increase according to the addition amount of nitrogen trifluoride. This tendency is remarkable in the range of small quantities addition amount under approximately 2.5 %. Comparing no addition of the addition gas and 2.5% addition, the etching rate is increased by 40%.

Since the etching rate tends to increase linearly according to the concentration of nitrogen trifluoride, when a mixed cleaning gas of nitrogen trifluoride and oxygen is used without using hexafluoropropene, it can be determined that the acceleration action of the etching reaction has occurred in the system of hexafluoropropene + oxygen in the range of small quantities of the addition gas besides the etching action by nitrogen trifluoride alone.

When more than 2.5% of nitrogen trifluoride is added, the increasing tendency 5 of the etching rate declines up to 8%, above which it increases again. The etching promotion reaction of nitrogen trifluoride may be saturated between 2.5% and 8% and the etching rate may be increased by the action of a nitrogen trifluoride alone from 8% or above.

Accordingly, the addition of 8% or more of nitrogen trifluoride is preferable and the addition of 2.5% or less of nitrogen trifluoride in the system of hexafluoropropene + oxygen is more preferable considering the utilization rate as an addition gas. The increasing tendency of the etching rate by nitrogen trifluoride is due to the action of F radicals generated by the plasma decomposition of nitrogen trifluoride on hexafluoropropene and the same effect of nitrogen trifluoride is obtained in the case of fluorine.

### Example 2

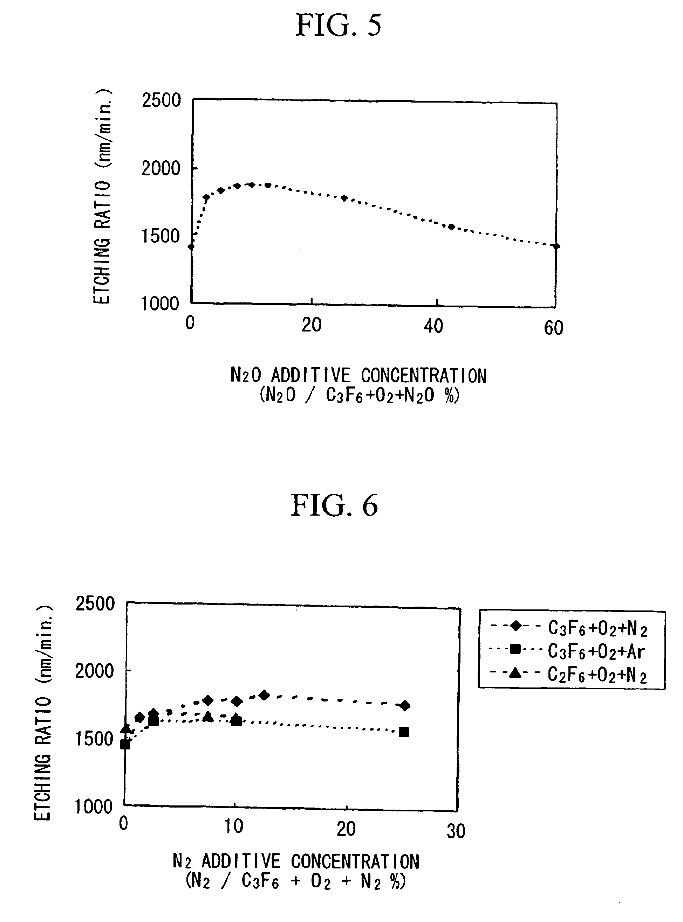

A mixed gas of hexafluoropropene and oxygen, to which is added nitrous oxide, was used as a cleaning gas. The mixing ratios of gases were the same as Example 1. The relationship of the measurement result of the addition amount of nitrous oxide and the etching rate is shown in FIG. 5.

From FIG. 5, the etching rate of the silicon oxide film tends to increase with the addition of nitrous oxide up to 10 %, above which it decreases. 10% or less of the addition amount of nitrous oxide is then preferable.

The increasing tendency of the etching rate is remarkable under the approximately addition range of 7.5% nitrous oxide and comparing no addition and the 7.5% addition, the etching rate is increased by 33%. Since nitrous oxide alone has no etching action to the silicone oxide film, the etching reaction accelerating action to the system of hexafluoropropene + oxygen is occurred in the 10% or less range of small quantities addition of nitrous oxide.

### Example 3

Mixed gases of hexafluoropropene and oxygen, to which is added nitrogen or argon respectively, were used as cleaning gases. The relationship of the measurement result between each addition amounts of nitrogen and argon, and the etching rate is shown in FIG. 6.

From FIG. 6, the etching rate of the silicon oxide film tends to increase by addition of nitrogen or argon or both. In the case of nitrogen, the increasing is remarkable under the approximately 10% addition range and comparing no addition and the 10% addition, the etching rate is increased by 23%. In the case of argon, the etching rate tends to increase gradually according to the addition amount and the 10% increase of the etching rate is observed at the 10% addition. This addition effect of argon resulted in the etching rate being lower than that of nitrogen. The spark-over voltage of nitrogen and argon is almost the same; however, due to the action of N₂ radical or N radical is provided when nitrogen is added, for example, the reaction-active double bond of hexafluoropropene molecule act with these radicals, the effect to assist the active species generation reaction is assumed to be added. Since the etching reaction rate is decreased when the addition gas amount is above 10%, it is preferable to be 10% or less of the addition amount of nitrogen or argon considering the gas consumption effect.

### Example 4 (not being part of the invention)

A mixed gas of hexafluoroethane and oxygen, to which is added nitrogen, is used as a cleaning gas. The etching rate by this cleaning gas had the same tendency of that of the cleaning gas of Example 3 to which is added argon, and 10% increase of the etching rate at 10% addition. Since hexafluoroethane has no reaction-active double bond per molecule, the effect of N₂ radicals or N radicals cannot be obtained and it is interpreted that only the decreasing effect of the spark-over voltage appeared. In this case also, the etching reaction rate is decreased when above 10% of the addition gas amount and 10% or less addition of nitrogen is preferable considering the gas consumption effect.

In both cases of Examples 3 and 4, since nitrogen alone or argon alone has no etching action to the silicon oxide film, it is supposed that the etching acceleration action in the system of hexafluoropropene + oxygen or the system of hexafluoroethane + oxygen in 10% or less addition of the small quantities of addition range occurred.

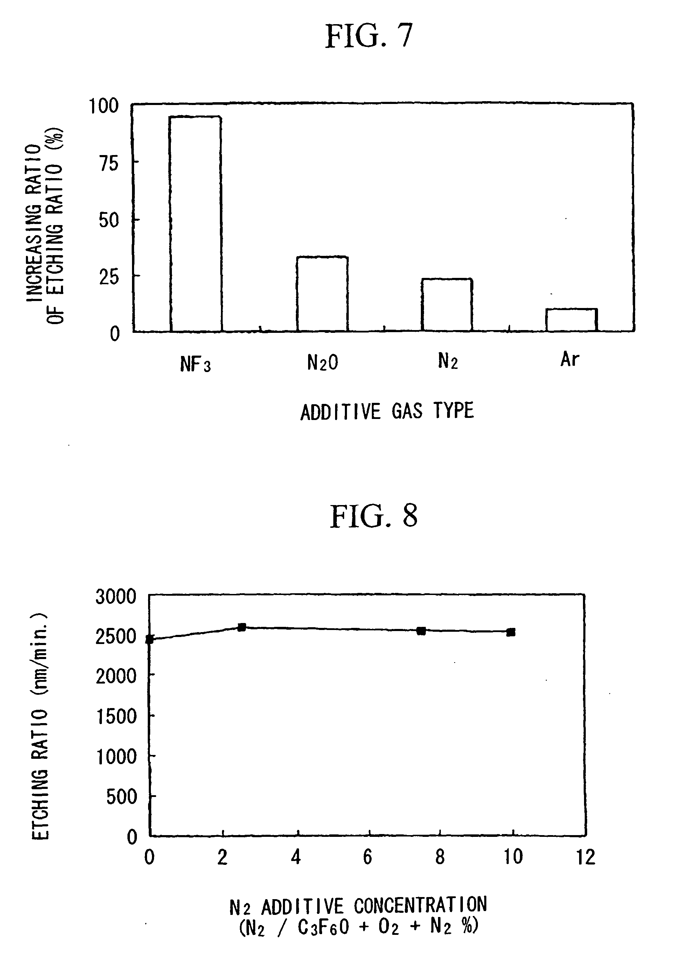

The increasing ratios of the etching rate when 10% addition gases is added respectively in Examples 1 to 4 are shown collectively in FIG.7.

### Example 5

A mixed gas of hexafluoropropene and oxygen, to which is added nitrogen and nitrogen trifluoride, is used as a cleaning gas. The etching rate of the silicon oxide film is measured at 5% addition amount of nitrogen and nitrogen trifluoride each. The etching rate is increased by 40% when the addition gas is nitrogen only, and is increased by 10% when the addition gas is nitrogen trifluoride only, and it is assumed that the effect of each addition gas is at least additive.

### Example 6 (not being part of the invention)

A mixed gas of hexafluoropropene oxide and oxygen, to which is added nitrogen, was used as a cleaning gas. The relationship of the measurement result of the addition amount of nitrogen and the etching rate is indicated in FIG. 8.

From FIG. 8, the etching rate of the silicon oxide film tends to increase with the addition of nitrogen up to 2.5%, above which it decreases. The increasing tendency of the etching rate was remarkable under the approximately 2.5% addition range of nitrogen addition amount, and comparing no addition and the 2.5% addition, the etching rate is increased by 6%.

Since nitrogen alone has no etching action on silicon oxide film, it appears that the etching acceleration action to hexafluoropropene oxide + oxygen in the small quantities range of nitrogen addition occurred.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A cleaning gas to remove deposits accumulated inside a semiconductor film forming apparatus, comprising:
an unsaturated fluorocarbon gas selected from the group consisting of hexafluoropropene, octafluorocyclopentene and hexafluorobutadiene;
oxygen; and
at least one selected from nitrogen trifluoride, fluorine, nitrous oxide, nitrogen, and rare gases up to 10% by volume based on a total gas volume.

2. A cleaning method to remove deposits accumulated inside a semiconductor film forming apparatus, comprising:
a step of introducing at least one cleaning gas selected from a gas according to claim 1 into the semiconductor film forming device, and
a step of plasma excitation of the cleaning gas by impressing high frequency electromagnetic radiation.

## Patentansprüche

1. Reinigungsgas zum Entfernen von Ablagerungen, die sich in einem Apparat zur Herstellung von halbleitendem Film angesammelt haben, umfassend:
ein ungesättigtes Fluorkohlenstoffgas, ausgewählt aus der Gruppe bestehend aus Hexafluorpropen, Octafluorcyclopenten und Hexafluorbutadien;
Sauerstoff; und
mindestens eines ausgewählt aus Stickstofftrifluorid, Fluor, Distickstoffoxid, Stickstoff, und seltene Gase von bis zu 10 Vol.-% auf dem Gesamtgasvolumen basierend.

2. Reinigungsverfahren zum Entfernen von Ablagerungen, die sich in einem Apparat zur Herstellung von halbleitendem Film angesammelt haben, umfassend:
den Schritt des Einführens von mindestens einem Reinigungsgas, ausgewählt aus einem Gas nach Anspruch 1 in den Apparat zur Herstellung von halbleitendem Film, und
den Schritt der Plasmaerregung des Reinigungsgases, indem eine hochfrequente elektromagnetische Strahlung auf es ausgeübt wird.

## Revendications

1. Gaz nettoyant pour éliminer des dépôts accumulés à l'intérieur d'un appareil de formation de film semiconducteur, comprenant:
un gaz de fluorocarbone non saturé sélectionné dans le groupe consistant en hexafluoropropène, octafluorocyclopentène et hexafluorobutadiène;
de l'oxygène; et
au moins un parmi le trifluorure d'azote, le fluor, l'oxyde nitreux, l'azote, et des gaz rares jusqu'à 10% en volume sur la base d'un volume de gaz total.

2. Procédé de nettoyage pour éliminer des dépôts accumulés à l'intérieur d'un appareil de formation de film semiconducteur, comprenant:
une étape d'introduction d'au moins un gaz nettoyant sélectionné parmi un gaz selon la revendication 1 dans l'appareil de formation de film semiconducteur, et
une étape d'excitation du plasma du gaz nettoyant en le soumettant à une radiation électromagnétique de haute fréquence.
